# EUROPEAN PATENT SPECIFICATION

(11) **EP 3 051 932 B1**
(45) Date of publication and mention of the grant of the patent: **29.11.2017**
(21) Application number: 16153177.7
(22) Date of filing: 28.01.2016
(51) Int. Cl.: C25D 5/12, C23C 18/16, C23C 18/38, H05K 9/00

(54) **STRUCTURE FOR SHIELDING ELECTROMAGNETIC WAVES**
STRUKTUR ZUR ABSCHIRMUNG ELEKTROMAGNETISCHER WELLEN
STRUCTURE DE PROTECTION CONTRE LES ONDES ÉLECTROMAGNÉTIQUES

(30) Priority: 29.01.2015 KR 20150014374
(43) Date of publication of application: 03.08.2016
(73) Proprietor: LG Innotek Co., Ltd., Seoul, 04637 (KR)
(72) Inventor: HYUN, Soon Young, 04637 Seoul (KR); BAE, Seok, 04637 Seoul (KR); YOON, Hyung, 04637 Seoul (KR); KWON, Yong Jae, 04637 Seoul (KR); LEE, Hyung Eui, 04637 Seoul (KR)
(74) Representative: Zardi, Marco

(56) References cited:
- WO-A2-2004/114731
- JP-A- 2000 212 759
- US-A- 4 542 076
- US-A1- 2009 092 762
- US-A1- 2009 256 244
- US-A1- 2010 120 962

## Description

### BACKGROUND

### 1. Field of the Invention

The present invention relates to a structure capable of efficiently shielding electromagnetic waves of an electronic component.

### 2. Discussion of Related Art

Recently, as components in an electronic product are integrated and a process speed is accelerated, performance for each component is maximized, but there is a problem in which a malfunction, performance degradation, and deterioration caused by an electromagnetic interference between adjacent components are generated.

Shielding of electromagnetic interference (EMI) is implemented, using a metal member, on a functionally classified unit device to prevent an electromagnetic interference between adjacent electronic components and improve performance.

However, in the case of the metal member, there are problems in which a device which is an object should be widely covered, an adjacent device and a device which is not related to the corresponding performance should be also covered, and the height of the metal member, the thickness of a material of the metal member, etc. should be considered depending on electronic components. Also, since it is difficult for the shielding of EMI to be completely performed, EMI leak frequently occurs on a surface of a printed circuit board to which an electronic component is mounted and at a portion to which the above-described metal member is coupled.

Further examples of structures for shielding electromagnetic waves are known from each of prior art documents WO 2004/114731, JP 2000212759, US 4542076 and US 2009/092762.

### SUMMARY OF THE INVENTION

The present invention is directed to a structure for shielding electromagnetic waves capable of fundamentally blocking EMI leak by forming a functional layer for shielding electromagnetic waves therein, and minimizing performance degradation and malfunction of electronic components by efficiently shielding various electronic devices from electromagnetic waves.

According to an aspect of the present invention, there is provided a structure for shielding electromagnetic waves including an electromagnetic wave generating source that generates electromagnetic waves, a shielding structure arranged to surround the electromagnetic wave generating source, and metal layers for shielding electromagnetic waves having surface roughness on inner surfaces of upper and side portions of the shielding structure.

According to the embodiment of the present invention, the structure for shielding electromagnetic waves can fundamentally block EMI leak by forming a functional layer for shielding electromagnetic waves therein, and minimize performance degradation and malfunction of electronic components by efficiently shielding various electronic devices from electromagnetic waves.

Particularly, the structure for shielding electromagnetic waves can prevent a side slipping phenomenon or a blister phenomenon, in which a defect such as a blister occurs on a surface of a component, from occurring when reliability of the electronic component is examined by forming a functional layer therein using a surface treated structure and a plated layer, and can increase reliability by maximizing the shielding rate of the side portion of the structure for shielding electromagnetic waves.

### BRIEF DESCRIPTION OF THE DRAWINGS

The above and other objects, features and advantages of the present invention will become more apparent to those of ordinary skill in the art by describing in detail exemplary embodiments thereof with reference to the accompanying drawings, in which:
FIG. 1 is a conceptual view of a package to which a structure for shielding electromagnetic waves according to one embodiment of the present invention is applied;
FIG. 2 is an enlarged conceptual view of the structure for shielding electromagnetic waves in FIG. 1;
FIG. 3 is a flowchart illustrating a process of implementing surface roughness of the shielding structure according to one embodiment of the present invention;
FIG. 4A is an enlarged image of a right inner surface of the shielding structure according to one embodiment of the present invention, and FIG. 4B is an enlarged image of a left inner surface thereof;
FIGS. 5A to 5C are result tables that show whether a blister phenomenon occurs or not according to a range of the surface roughness of inner surfaces of upper and side portions of the shielding structure according to one embodiment of the present invention;
FIG. 6 is an experiment graph of a shielding efficiency according to a thickness of a metal layer for shielding electromagnetic waves in one embodiment of the present invention; and
FIG. 7 is an experiment graph that shows electromagnetic wave shielding efficiency in a higher harmonics band of 1 to 10 GHz in the shielding structure with the structure same as in FIG. 6.

### DETAILED DESCRIPTION OF EXEMPLARY EMBODIMENTS

Hereinafter, configurations and operations according to the present invention will be described in detail with reference to the accompanying drawings. In the following description of the present invention, like elements denote like reference numerals regardless of symbols, and thus the description thereof will not be repeated. While such terms as first, second, etc., may be used to describe various components, such components should not be limited to the above terms. The above terms are used only to distinguish one component from another.

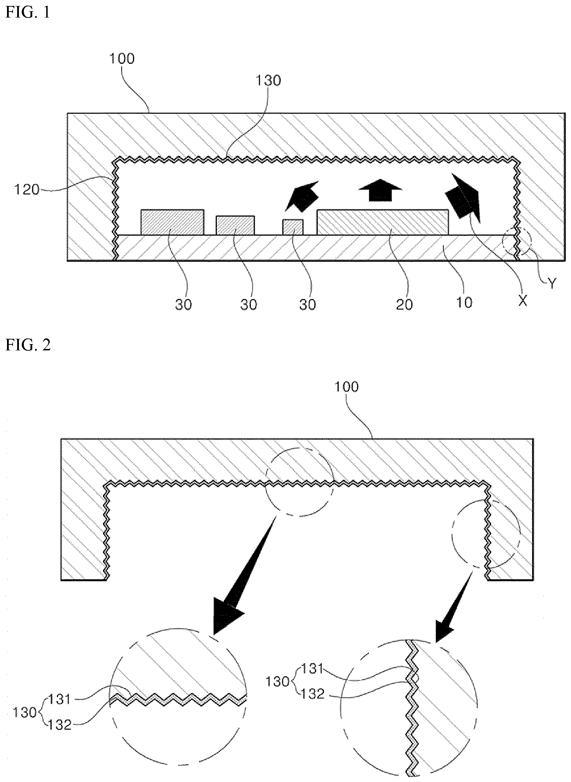

FIG. 1 is a conceptual view of a package to which a structure for shielding electromagnetic waves according to one embodiment of the present invention is applied, and FIG. 2 is an enlarged conceptual view of the structure for shielding electromagnetic waves in FIG. 1.

Referring to FIGS. 1 and 2, a structure for shielding electromagnetic waves according to the embodiment of the present invention may include an electromagnetic wave generating source 20 that generates electromagnetic waves, a shielding structure 100 arranged to surround the electromagnetic wave generating source 20, and metal layers 120 and 130 for shielding electromagnetic waves having surface roughness on an inner surface 131 of an upper portion of the shielding structure 100 and an inner surface 121 of a side portion thereof

Particularly, the metal layers 120 and 130 for shielding electromagnetic waves are surface-treated by performing a physical or chemical processing on the inner surface of the shielding structure 100. The metal layers 120 and 130 for shielding electromagnetic waves can prevent discordance of coefficient of thermal expansion (CTE) between materials, generated due to the nature of different materials between a surface of the shielding structure and a metal layer, and poor adhesion generated due to a difference of surface energy by forming metal layers on the surface-treated surface in a plating method and the like, and can prevent a blister phenomenon and a side slipping phenomenon by ensuring a surface area that sufficiently provides anchoring energy. Particularly, in this structure, a film is uniformly formed even on a side portion to prevent electromagnetic interference (EMI) leak generated from the side portion of the the shielding structure, and thus shielding performance can be increased.

The shielding structure 100 according to the embodiment of the present invention may be formed, as shown in FIG. 1, to entirely cover and surround an electronic component or an electronic device that becomes the various electromagnetic wave generating source 20.

Of course in this case, the electromagnetic wave generating source 20 is formed to be mounted on a substrate such as a printed circuit board 10. The shielding structure 100 is formed to be in close contact with the printed circuit board 10, and particularly in this case, the metal layer for shielding electromagnetic waves according to the embodiment of the present invention may be implemented at a contact portion between the shielding structure 100 and the printed circuit board 10, thereby blocking EMI leak on a contact surface (a coupled surface).

Specifically, the shielding structure 100 may be implemented with a physical processing or a chemical processing to have uniform surface roughness therein. When a thin metal layer is formed on the inner surface with the surface roughness through a plating process and the like, the metal layer may be also formed to have uniform surface roughness.

The surface roughness formed on the inner surface of the shielding structure 100 may be formed so that the surface roughness of the upper portion of the shielding structure and the surface roughness of the side portion thereof are the same, but may also be formed so that the surface roughness of the upper portion of the shielding structure and the surface roughness of the side portion thereof are different from each other depending on a degree of influence of electromagnetic waves.

In the embodiment of the present invention, the surface roughness (Ra) of the upper portion of the shielding structure may be in a range of 1 to 7.5 *µ*m, and the surface roughness of the side portion of the shielding structure may be in a range of 0.05 to 3.5 *µ*m. When the surface roughness is out of the range, a defect in which a blister phenomenon between the metal layer and a surface of the shielding structure or the chipping phenomenon, which is a local scratch, at an interface occurs is remarkably increased.

Further, the surface roughness in the shielding structure in the embodiment of the present invention may be implemented, as described above, in a method in which the surface roughness is naturally transferred to the metal layer by performing a surface treatment on the inner surface of the shielding structure through the physical and chemical processing, and then forming a metal layer. Otherwise, when the metal layer is formed on the inner surface of the shielding structure, a surface roughness processing may be performed by patterning the metal layer.

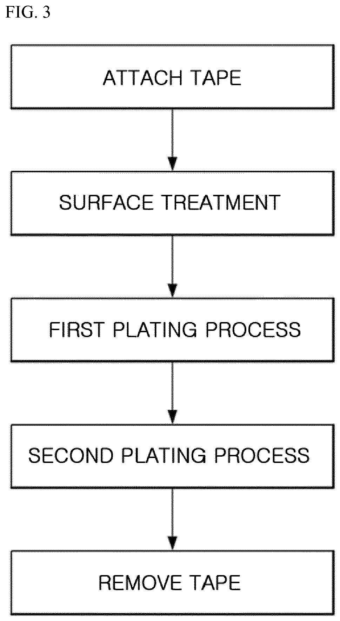

FIG. 3 is a flowchart illustrating a process of implementing surface roughness of the shielding structure according to the embodiment of the present invention.

Referring to FIG. 3, to form a metal layer for shielding electromagnetic waves with surface roughness on the shielding structure according to the embodiment of the present invention, a foam type tape is first attached to the inner surface of the shielding structure, and an area in which the surface roughness is implemented is formed.

After that, a surface treatment process is performed to implement the surface roughness on the inner surface of the shielding structure. The surface treatment process may be performed using a chemical surface treatment or a physical surface treatment method.

The chemical surface treatment method includes, as an example, a swelling method using glycol ether, an etching method using an etching solution, such as KMnO₄, or a neutralization method using acid liquid such as sulfuric acid.

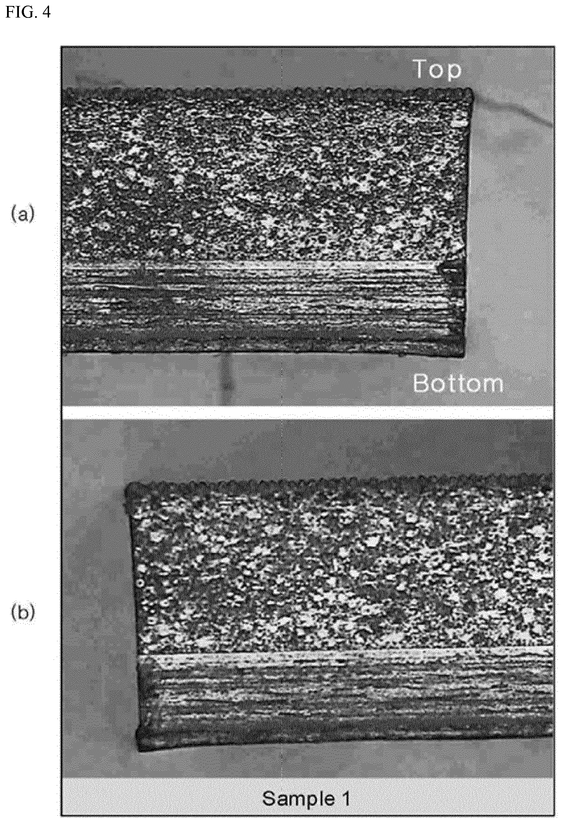

The physical surface treatment may include a method in which the surface roughness is implemented using electron beam (E-Beam), ultra violet (UV laser), or CO₂ laser. For example, when a processing is performed under the conditions in which electron energy is 30 keV, a diameter of E-Beam is 30 to 50 *µ*m, and an application time is 10 to 20 minutes, the surface roughness may be achieved as shown in FIG. 4. FIG. 4A is an enlarged image of a right inner surface of the shielding structure of the embodiment of the present invention, and the FIG. 4B is an enlarged image of a left inner surface of the shielding structure. Even in this case, as described above, it is preferable that the surface roughness (Ra) of the inner surface of the upper portion of the shielding structure be in a range of 1 to 7.5 *µ*m and the surface roughness (Ra) of the inner surface of the side portion thereof be in a range of 0.05 to 3.5 *µ*m. Particularly, to increase efficiency in the combination of the upper portion and the lower portion within the above-described range, it is further preferable that the surface roughness (Ra) of the inner surface of the upper portion be in a range of 1 to 7.0 *µ*m and the surface roughness (Ra) of the inner surface of the side portion be in a range of 0.1 to 3.0 *µ*m.

When the surface roughness is out of the above-described range, a defect rate caused by the blister phenomenon is remarkably increased.

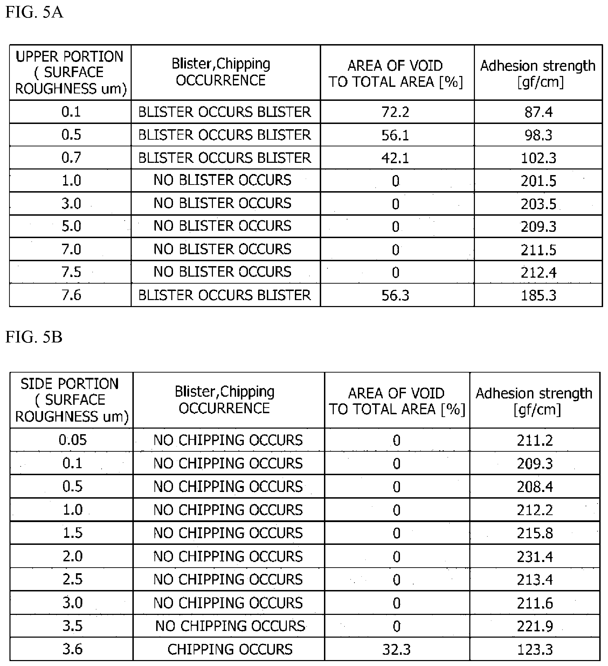

FIGS. 5A to 5C are result tables that show whether a blister phenomenon occurs or not depending on a range of the surface roughness of inner surfaces of upper and side portions of the shielding structure according to the embodiment of the present invention.

Referring to FIG. 5A, a result of the table shown in FIG. 5A shows a result of experimenting occurrence of the blister phenomenon or reliability of an adhesion property and the like with respect to the surface roughness of the inner surface of the upper portion of the shielding structure according to the embodiment of the present invention. As shown in FIG. 5A, the inner surface of the upper portion of the shielding structure corresponds to an area directly influenced by the electromagnetic waves. When the surface roughness is less than 1.0 *µ*m, the blister phenomenon occurs, and an area of a void to the total area is increased, and thus it may be confirmed that a relative adhesion strength is remarkably reduced. Also, when the surface roughness of the inner surface of the upper portion of the shielding structure is greater than 7.5 *µ*m, it may be confirmed that the blister phenomenon occurs again and surface adhesion is degraded. That is, in the case of the inner surface of the upper portion of the shielding structure, when the surface roughness (Ra) satisfies a range of 1 to 7.5 *µ*m, the blister phenomenon does not occur, and the adhesion strength is in a range of 201.5 to 212.4 gf/cm, and thus it may be confirmed that remarkably high reliability is ensured.

FIG. 5B is an experimental result table which shows whether a blister phenomenon or a chipping phenomenon occurs and shows that adhesion reliability is evaluated according to a change in the surface roughness of the side portion of the shielding structure according to the embodiment of the present invention. Referring to FIG. 5B, when the surface roughness of the side portion of the shielding structure is in a range of 0.05 to 3.5 *µ*m, a blister phenomenon or chipping phenomenon does not occur compared to the entire area, and the adhesion strength is also excellent in a range of 208.4 to 231.4 gf/cm. However, when the surface roughness is out of the range, the blister phenomenon or chipping phenomenon occurs, and the adhesion strength is remarkably reduced, for example, to 123.3 gf/cm. When the surface roughness is less than 0.05 *µ*m, an effect for the surface roughness treatment is hardly shown.

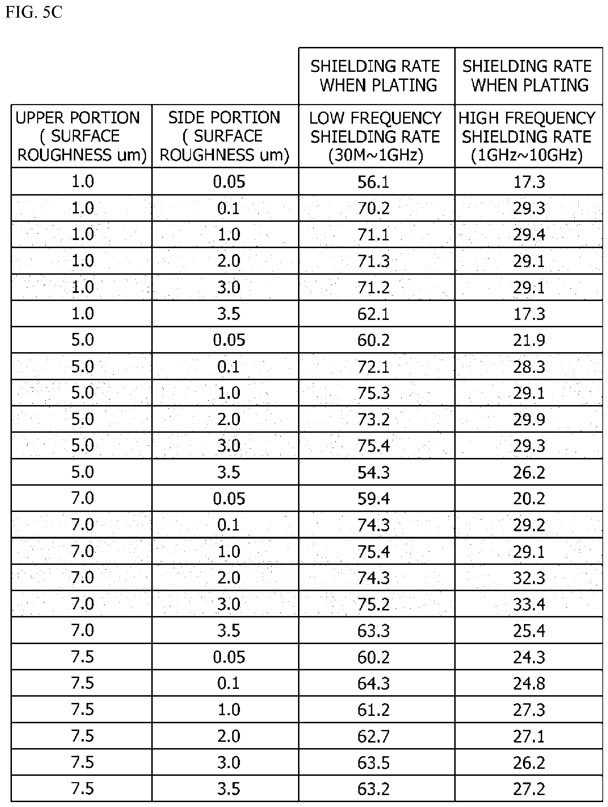

FIG. 5C shows a comparison between results in which a high frequency shielding rate and a low frequency shielding rate are measured based on the combination of the surface roughness of the surfaces of the upper and side portions within a range of the surface roughness in FIGS. 5A and 5B.

As shown in FIG. 5C, in the experimental example in which the surface roughness of the inner surface of the upper portion of the shielding structure according to the embodiment of the present invention in a range of 1.0 to 7.0 *µ*m and the surface roughness of the inner surface of the side portion thereof in a range of 0.1 to 3.0 *µ*m are combined, it is confirmed that the low frequency shielding rate and the high frequency shielding rate are remarkably excellent. In FIGS. 5A and 5B, when the surface roughness of the inner surface of the upper portion is in a range of 7.0 to 7.5 *µ*m, blister phenomenon prevention efficiency or adhesion reliability is excellent, but when the surface roughness of the inner surface of the side portion is changed from 0.05 to 0.1 *µ*m or from 3.0 to 3.5 *µ*m, some losses of the low frequency and high frequency shielding rates are caused.

Therefore, it is preferable that the surface roughness (Ra) of the inner surface of the upper portion of the shielding structure according to the embodiment of the present invention be in a range of 1 to 7.5 *µ*m and the surface roughness (Ra) of the inner surface of the side portion be in a range of 0.05 to 3.5 *µ*m. Particularly, to further increase the efficiency in the event of combination of the upper portion and the lower portion within the above-described range, it is preferable that the surface roughness (Ra) of the inner surface of the upper portion be in a range of 1 to 7.0 *µ*m and the surface roughness (Ra) of the inner surface of the side portion be in a range of 0.1 to 3.0 *µ*m.

After the process of forming the surface roughness, the metal layer may be formed through a first plating process. In this case, the metal layer has a first metal layer (for example, a Cu metal layer) formed through an electroless plating, and the Cu metal layer may have an improved adhesion to a surface by the surface roughness of the surface of the shielding structure and may be formed to have uniform surface roughness.

After that, a process in which at least two layers are laminated on the above-describe first metal layer through a second plating process may be performed. The metal layer may be implemented in a structure in which the metal layers of Cu and Ni are laminated on the first metal layer using an electroplating method.

Subsequently, the foam type tape is removed, and the process is completed. When the foam type tape is removed, a burr generated at an interface of the contacted metal layer can be remarkably reduced.

In the above-describe process, the thickness of the metal layer for shielding electromagnetic waves in the embodiment of the present invention may be in a range of 0.1 to 15 *µ*m, and particularly when the thickness is in a range of 12 *µ*m or less, the efficiency can be increased by approximately 250% compared to the shielding rate measured when the metal layer does not exist.

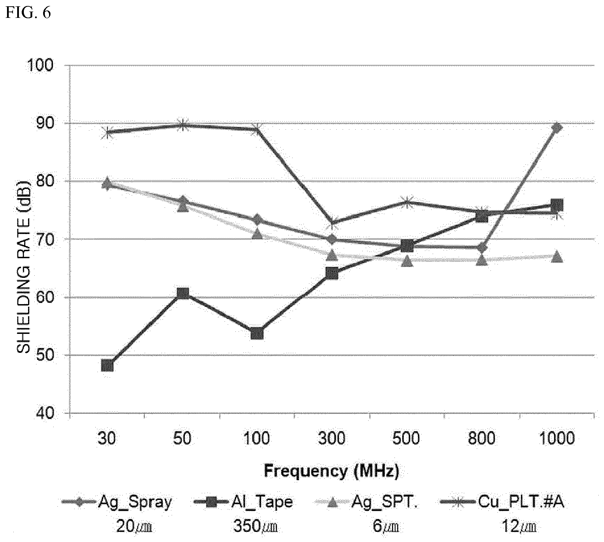

FIG. 6 is a result of experimenting electromagnetic wave shielding efficiency in a low frequency band of 30 MHz to 1 GHz when the metal layer for shielding electromagnetic waves in the embodiment of the present invention is formed with an electroless Cu-plated layer to be in a thickness of 12 *µ*m, the surface roughness of the upper portion of the shielding structure is in a range of 1.0 to 7.0 *µ*m, at an average of 5 *µ*m, and the surface roughness of the side portion thereof is in a range of 0.1 to 3.0 *µ*m, at an average of 2 *µ*m. As a comparative example, an Ag metal layer formed in a thickness of 20 *µ*m through a spray process, an Al tape formed in a thickness of 350 *µ*m, and Ag formed in a thickness of 6 *µ*m through a silver plating (SPT) are compared to each other. Consequently, in the entire band of the frequency, the shielding efficiency in the example in which the electroless Cu-plated layer is formed to be in a thickness of 12 *µ*m is high (improved by approximately 4dB and 250%).

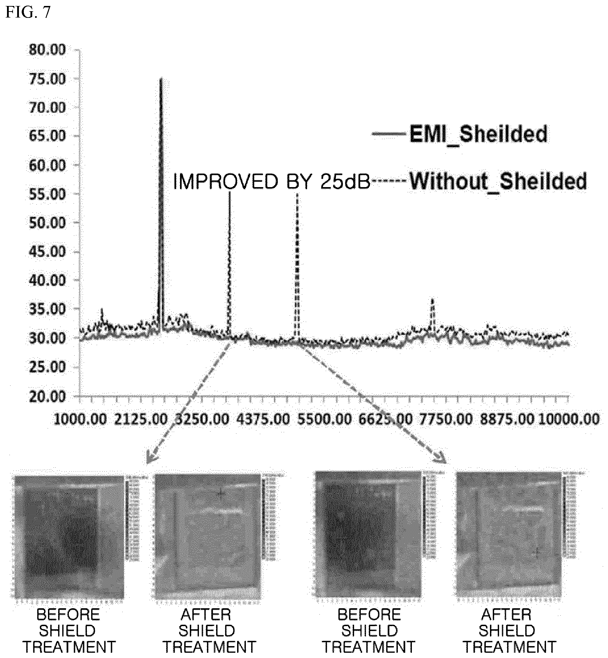

FIG. 7 is a graph that shows the electromagnetic wave shielding efficiency in a higher harmonics band of 1 to 10 GHz in the shielding structure with a structure same as in FIG. 6, and a graph in which the shielding efficiency of an example in which the metal layer is formed is compared to that of the comparative example in which the metal layer is not formed. Generally, it is confirmed that the shielding efficiency is improved by approximately 25 dB in the shielding structure according to the embodiment of the present invention.

While embodiments have been described above in detail, various changes may be made without departing from the spirit and scope of the present invention. The spirit and scope of the invention are defined not by the detailed description of the invention but by the appended claims, and encompass equivalents that fall within the scope of the appended claims.

### < DESCRIPTION OF SYMBOLS >

10: PRINTED CIRCUIT BOARD
20: ELECTROMAGNETIC WAVE GENERATING SOURCE
30: ADJACENT DEVICE
100: SHIELDING STRUCTURE
120, 130: METAL LAYERS FOR SHIELDING ELECTROMAGNETIC WAVES
121, 131: SURFACES
122, 132: METAL PLATED LAYERS

## Claims

1. A structure for shielding electromagnetic waves comprising:
an electromagnetic wave generating source(20) configured to generate electromagnetic waves;
a shielding structure(100) arranged to surround at least part of the electromagnetic wave generating source(20); and
metal layers(120, 130) formed on inner surfaces(121, 131) of upper and side portions of the shielding structure(100) and having predetermined surface roughness,
wherein the surface roughness (Ra) of the inner surface(131) of the upper portion of the shielding structure(100) is in a range of 1 to 7.0 *µ*m, and
wherein the surface roughness (Ra) of the inner surface(121) of the side portion of the shielding structure(100) is in a range of 0.1 to 3.0 *µ*m.

2. The structure for shielding electromagnetic waves of claim 1, wherein thickness of the metal layer(120, 130) is in a range of 1 to 10 *µ*m.

3. The structure for shielding electromagnetic waves of claim 2, wherein the surface roughness is formed on the inner surfaces(121, 131) of the upper and side portions of the shielding structure(100).

4. The structure for shielding electromagnetic waves of claim 2, wherein the surface roughness is formed by patterning the metal layer(120, 130).

5. The structure for shielding electromagnetic waves of claim 1, wherein the metal layer(120, 130) includes a first metal layer and a second metal layer formed on the first metal layer.

6. The structure for shielding electromagnetic waves of claim 5, wherein the first metal layer includes Cu, and the second metal layer includes at least one of Cu and Ni.

7. The structure for shielding electromagnetic waves of claim 1, wherein the metal layer(120, 130) has a laminated structure including at least one of an electroless Cu plated layer, an electro Cu plated layer, and electro Ni plated layer.

8. An electronic device comprising:
a printed circuit board(10) and a structure for shielding electromagnetic waves according to claim 1,
wherein the electromagnetic wave generating source(20) configured to generate electromagnetic waves is an electronic component(20) which is mounted on the printed circuit board(10).

9. The electronic device of claim 8, wherein the metal layer(120, 130) has a laminated structure including at least one of an electroless Cu plated layer, an electro Cu plated layer, and electro Ni plated layer..

10. The electronic device of claim 8, wherein thickness of the metal layer(120, 130) is in a range of 1 to 10 *µ*m.

11. The electronic device of claim 8, wherein the surface roughness is formed on the inner surfaces(121, 131) of the upper and side portions of the shielding structure(100).

## Patentansprüche

1. Struktur zum Abschirmen elektromagnetischer Wellen umfassend:
eine Elektromagnetwellenerzeugungsquelle (20), die dazu konfiguriert ist, elektromagnetische Wellen zu erzeugen;
eine Abschirmungsstruktur (100), die dazu angeordnet ist, wenigstens einen Teil der Elektromagnetwellenerzeugungsquelle (20) zu umgeben; und
Metallschichten (120, 130), die an Innenflächen (121, 131) von oberen und seitlichen Abschnitten der Abschirmungsstruktur (100) gebildet sind und eine vorgegebene Oberflächenrauhigkeit aufweisen,
wobei die Oberflächenrauhigkeit (Ra) der Innenfläche (131) des oberen Abschnitts der Abschirmungsstruktur (100) in einem Bereich von 1 bis 7,0 µm liegt, und
wobei die Oberflächenrauhigkeit (Ra) der Innenfläche (121) des seitlichen Abschnitts der Abschirmungsstruktur (100) in einem Bereich von 0,1 bis 3,0 µm liegt.

2. Struktur zum Abschirmen elektromagnetischer Wellen nach Anspruch 1, wobei die Dicke der Metallschichten (120, 130) in einem Bereich von 1 bis 10 µm liegt.

3. Struktur zum Abschirmen elektromagnetischer Wellen nach Anspruch 2, wobei die Oberflächenrauhigkeit an den Innenflächen (121, 131) der oberen und seitlichen Abschnitte der Abschirmungsstruktur (100) gebildet ist.

4. Struktur zum Abschirmen elektromagnetischer Wellen nach Anspruch 2, wobei die Oberflächenrauhigkeit durch Patterning der Metallschichten (120, 130) gebildet ist.

5. Struktur zum Abschirmen elektromagnetischer Wellen nach Anspruch 1, wobei die Metallschicht (120, 130) eine erste Metallschicht und eine auf der ersten Metallschicht gebildete zweite Metallschicht umfasst.

6. Struktur zum Abschirmen elektromagnetischer Wellen nach Anspruch 5, wobei die erste Metallschicht Cu umfasst und die zweite Metallschicht Cu und/oder Ni umfasst.

7. Struktur zum Abschirmen elektromagnetischer Wellen nach Anspruch 1, wobei die Metallschicht (120, 130) einen schichtartigen Aufbau aufweist, der eine stromlos plattierte Cu-Schicht, eine elektroplattierte Cu-Schicht und/oder eine elektroplattierte Ni-Schicht umfasst.

8. Elektronische Vorrichtung umfassend:
eine Leiterplatte (10) und eine Struktur zum Abschirmen elektromagnetischer Wellen nach Anspruch 1, wobei die Elektromagnetwellenerzeugungsquelle (20), die dazu konfiguriert ist, elektromagnetische Wellen zu erzeugen, eine elektronische Komponente (20) ist, die auf der Leiterplatte (10) montiert ist.

9. Elektronische Vorrichtung nach Anspruch 8, wobei die Metallschicht (120, 130) einen schichtartigen Aufbau aufweist, der eine stromlos plattierte Cu-Schicht, eine elektroplattierte Cu-Schicht und/oder eine elektroplattierte Ni-Schicht umfasst.

10. Elektronische Vorrichtung nach Anspruch 8, wobei die Dicke der Metallschicht (120, 130) in einem Bereich von 1 bis 10 µm liegt.

11. Elektronische Vorrichtung nach Anspruch 8, wobei die Oberflächenrauhigkeit an den Innenflächen (121, 131) der oberen und seitlichen Abschnitte der Abschirmungsstruktur (100) gebildet ist.

## Revendications

1. Une structure de protection contre les ondes électromagnétiques comprenant :
une source (20) de génération d'ondes électromagnétiques configurée pour générer des ondes électromagnétiques ;
une structure (100) formant écran agencée pour entourer au moins une partie de la source (20) de génération d'ondes électromagnétiques ; et
des couches métalliques (120, 130) formées sur des surfaces intérieures (121, 131) des parties supérieure et latérales de la structure (100) formant écran et ayant une rugosité de surface prédéterminée,
la rugosité de surface (Ra) de la surface intérieure (131) de la partie supérieure de la structure (100) formant écran étant comprise entre 1 et 7,0 µm, et
la rugosité de surface (Ra) de la surface intérieure (121) de la partie latérale de la structure (100) formant écran étant comprise entre 0,1 à 3,0 µm.

2. La structure de protection contre les ondes électromagnétiques selon la revendication 1, dans laquelle l'épaisseur de la couche métallique (120, 130) se situe dans une plage allant de 1 à 10 µm.

3. La structure pour protéger les ondes électromagnétiques de la revendication 2, dans laquelle la rugosité de surface est formée sur les surfaces intérieures (121, 131) des parties supérieure et latérales de la structure (100) formant écran.

4. La structure pour protéger les ondes électromagnétiques de la revendication 2, dans laquelle la rugosité de surface est formée en façonnant un motif dans la couche métallique (120, 130).

5. La structure de protection contre les ondes électromagnétiques selon la revendication 1, dans laquelle la couche métallique (120, 130) comprend une première couche métallique et une deuxième couche métallique formée sur la première couche métallique.

6. La structure pour protéger les ondes électromagnétiques selon la revendication 5, dans laquelle la première couche métallique comprend du Cu et la deuxième couche métallique comprend au moins l'un parmi le Cu et le Ni.

7. La structure de protection contre les ondes électromagnétiques selon la revendication 1, dans laquelle la couche métallique (120, 130) a une structure stratifiée comprenant au moins une parmi : une couche de plaquage de Cu non électrolytique, une couche de Cu électroplaquée et une couche de Ni électroplaquée.

8. Un dispositif électronique comprenant :
une carte de circuit imprimé (10) et une structure de protection contre les ondes électromagnétiques selon la revendication 1,
dans lequel la source (20) de génération d'ondes électromagnétiques configurée pour générer des ondes électromagnétiques est un composant électronique (20) qui est monté sur la carte de circuit imprimé (10).

9. Le dispositif électronique selon la revendication 8, dans lequel la couche métallique (120, 130) présente une structure stratifiée comprenant au moins une parmi : une couche de plaquage de Cu non électrolytique, une couche de Cu électroplaquée et une couche de Ni électroplaquée.

10. Le dispositif électronique selon la revendication 8, dans lequel l'épaisseur de la couche métallique (120, 130) se situe dans une plage allant de 1 à 10 µm.

11. Le dispositif électronique selon la revendication 8, dans lequel la rugosité de surface est formée sur les surfaces intérieures (121, 131) des parties supérieure et latérales de la structure (100) formant écran.
